# EUROPEAN PATENT SPECIFICATION

(11) **EP 3 780 269 B1**
(45) Date of publication and mention of the grant of the patent: **31.05.2023**
(21) Application number: 18915934.6
(22) Date of filing: 14.11.2018
(51) Int. Cl.: H01Q 9/04, H01Q 1/22

(54) **PACKAGING STRUCTURE**
VERPACKUNGSSTRUKTUR
STRUCTURE DE MISE SOUS BOÎTIER

(30) Priority: 25.04.2018 CN 201810378310
(43) Date of publication of application: 17.02.2021
(73) Proprietor: HUAWEI TECHNOLOGIES CO., LTD., Shenzhen, Guangdong 518129 (CN)
(72) Inventor: QU, Heng, Shenzhen, Guangdong 518129 (CN); CHANG, Ming, Shenzhen, Guangdong 518129 (CN); DONG, Hailin, Shenzhen, Guangdong 518129 (CN); LI, Xinhong, Shenzhen, Guangdong 518129 (CN); LIU, Liangsheng, Shenzhen, Guangdong 518129 (CN); YIN, Hongcheng, Shenzhen, Guangdong 518129 (CN)
(74) Representative: Maiwald GmbH
(86) International application number: PCT/CN2018/115459
(87) International publication number: WO 2019/205591

(56) References cited:
- CN-A- 101 083 359
- CN-A- 105 990 660
- CN-A- 106 450 732
- CN-U- 206 271 873
- CN-U- 206 532 878
- CN-U- 206 685 527
- JP-A- H03 254 208
- JP-A- 2012 054 917
- US-A- 3 665 480
- US-A- 5 055 852
- US-A- 5 539 420
- US-A1- 2007 052 587

## Description

### TECHNICAL FIELD

This application relates to an antenna, and in particular, to a packaging structure.

### BACKGROUND

An antenna in package is a technology in which an antenna and a chip are integrated into a package based on a packaging material and a packaging process, to implement a system-level wireless function. The antenna in package provides a good antenna solution for a system-level antenna chip because the antenna in package is well balanced between antenna performance, costs, and a volume. Therefore, it is favored by a large quantity of chip and package manufacturers, and also becomes an important antenna solution for a millimeter wave mobile communications system of the 5th generation mobile communication technology (5G).

US 5 539 420 A describes a plane antenna suitable for space applications in particular comprises a passive resonator coupled to a feedline by a looped slot. JP H03 254208 A describes an antenna in terms of an electromagnetic radiation emitting element. US 5 055 852 A describes a diplexing radiating element. US 2007/052587 A1 describes a multilayer stacked patch antenna fed by four orthogonal slots.

A packaged dual-polarized antenna array may implement a parallel dual-polarized operation manner, can form two beams to support beam scanning with high enough precision, and can maintain a transmit mode and a receive mode, thereby doubling a quantity of served users. A conventional single-polarized slot-coupled antenna has advantages of a wide bandwidth and a high gain, and includes a parasitic patch, a feeding stub, and a slot. The feeding stub is mainly used to couple and feed a plurality of types of slots. To implement packaging of a dual-polarized antenna, a single-polarized slot-coupled antenna needs to be implemented in a same-layer feeding manner. However, in this manner, feeding stubs interfere with each other, and this cannot be implemented structurally.

How to obtain a packaging structure of a wide bandwidth and a high gain is an urgent problem to be resolved.

### SUMMARY

This application provides a packaging structure to implement a packaging structure of a wide bandwidth and a high gain.

According to a first aspect forming part of the invention, this application provides a packaging structure, including:
a first radiation plate, a second radiation plate, and a feeding part, where
the second radiation plate is disposed below the first radiation plate; a slot is disposed on the second radiation plate, where the slot is in a ring shape; and the feeding part is disposed below the second radiation plate.

The feeding part includes a first feeding stub and a second feeding stub that are disposed independently of each other, where the first feeding stub and the second feeding stub are perpendicular to each other and disposed on a substrate below the slot, and the first feeding stub and the second feeding stub feed the first radiation plate by using the slot.

According to the packaging structure provided in the first aspect, by disposing the ring-shaped slot, the first radiation plate, and the second radiation plate, a bandwidth and a gain can be increased, implementing a wide bandwidth and a high gain. Further, an operating bandwidth of an antenna is extended to a wider frequency band, and the packaging structure is applicable to a terminal operating on a wide frequency band, expanding an application scope of the antenna. In addition, the slot is set to be in a ring shape, and the two feeding stubs are perpendicular to each other. In this case, electric fields corresponding to the two feeding stubs are orthogonal, and comparatively good isolation is achieved between electric fields generated by feeding by the two feeding stubs, thereby implementing comparatively high polarization isolation.

In a possible design, the first feeding stub includes a main body and a tail end, where the tail end is bent relative to the main body, the main body of the first feeding stub extends on a substrate on which the first feeding stub is located, one end of the main body of the first feeding stub is connected to a first signal line, and the other end of the main body of the first feeding stub is connected to the tail end of the first feeding stub; and
the second feeding stub includes a main body and a tail end, where the tail end is bent relative to the main body, the main body of the second feeding stub extends on a substrate on which the second feeding stub is located, one end of the main body of the second feeding stub is connected to a second signal line, and the other end of the main body of the second feeding stub is connected to the tail end of the second feeding stub.

In a possible design, at least a part of the tail end of the first feeding stub is located in a projection below the slot; and
at least a part of the tail end of the second feeding stub is located in a projection below the slot.

In a possible design, the first feeding stub and the second feeding stub are disposed on a same layer of substrate.

In a possible design, the slot is in a closed ring shape.

In a possible design, a shape of the slot is a circular ring, an elliptical ring, a rectangular ring, or a star ring.

In a possible design, a shape of the first radiation plate is a rectangle, a circle, or a cross.

In a possible design, the first radiation plate includes a substrate and a parasitic patch disposed on the substrate.

In a possible design, the packaging structure further includes:
a first ground plate that is disposed between the first signal line and the second signal line.

In a possible design, the packaging structure further includes: a second ground plate that is disposed at a bottom of the feeding part.

In the first aspect forming part of the invention, the packaging structure further includes a substrate and a chip that is fixedly connected to a side of the substrate, where the chip has a plurality of feeding pins, the plurality of feeding pins are connected to the substrate, and the substrate includes the first radiation plate, the second radiation plate, and the feeding part.

According to a second aspect not forming part of the invention, this application provides a terminal, including a radio frequency processing unit, a baseband processing unit, and a packaging structure according to the first aspect.

### BRIEF DESCRIPTION OF DRAWINGS

FIG. 1 is a side view of an embodiment of a packaging structure according to this application;
FIG. 2 is a bottom view of an embodiment of a packaging structure according to this application;
FIG. 3 is a top view of an embodiment of a packaging structure according to this application;
FIG. 4 is a bottom view of a feeding part in an embodiment of a packaging structure;
FIG. 5 is a bottom view of a feeding part in an embodiment of a packaging structure;
FIG. 6 is a bottom view of a feeding part in an embodiment of a packaging structure;
FIG. 7 is a bottom view of a feeding part in an embodiment of a packaging structure;
FIG. 8 is a top view of a first radiation plate;
FIG. 9 is a side view of an embodiment of a packaging structure according to this application;
FIG. 10 is a top view of an embodiment of a packaging structure according to this application;
FIG. 11 is a side view of an embodiment of a packaging structure according to this application;
FIG. 12 is a schematic diagram of distribution of a PP layer, a core layer, and a metal layer in a packaging structure according to this application;
FIG. 13 is a schematic diagram of an emulation result of a return loss of a packaging structure;
FIG. 14 is a schematic diagram of an emulation result of polarization isolation of a packaging structure;
FIG. 15 is a 3D radiation pattern of a packaging structure; and
FIG. 16 is a schematic structural diagram of an embodiment of a terminal according to this application.

### Description of reference signs in the accompanying drawings:

11: first radiation plate; 12: second radiation plate; 121: slot;
2: feeding part; 22: first feeding stub; 23: second feeding stub;
24: first signal line; 25: second signal line; and
31: first ground plate; 32: second ground plate; 33: third ground plate; 3: top-layer substrate.

### DESCRIPTION OF EMBODIMENTS

This application provides a packaging structure and an antenna array, which can implement a wide bandwidth and a high gain, feature comparatively high polarization isolation, a simple structure, and a small size, and may be applied to a full-duplex communications system, or may be used as a multiple-input multiple-output (MIMO) antenna, or may be applied in any other possible application scenario.

To implement a packaging structure of a wide bandwidth and a high gain, this application provides a packaging structure, including a first radiation plate, a second radiation plate, and a feeding part. A ring-shaped slot is disposed on the second radiation plate, the feeding part is disposed below the second radiation plate, and the feeding part includes a first feeding stub and a second feeding stub that are disposed independently of each other. The two feeding stubs feed the first radiation plate by being electromagnetically coupled to the slot. Disposing of the ring-shaped slot and the first radiation plate can increase a bandwidth and a gain, thereby implementing a wide bandwidth and a high gain. In addition, the slot is set to be in a ring shape, and the two feeding stubs are perpendicular to each other. In this case, electric fields corresponding to the two feeding stubs are orthogonal, and comparatively good isolation is achieved between electric fields generated by feeding by the two feeding stubs, thereby implementing comparatively high polarization isolation, a simple structure, and a small size. The following describes the technical solutions of this application in detail with reference to the accompanying drawings.

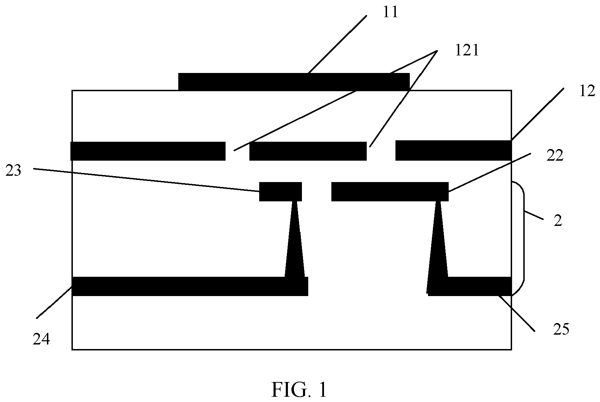

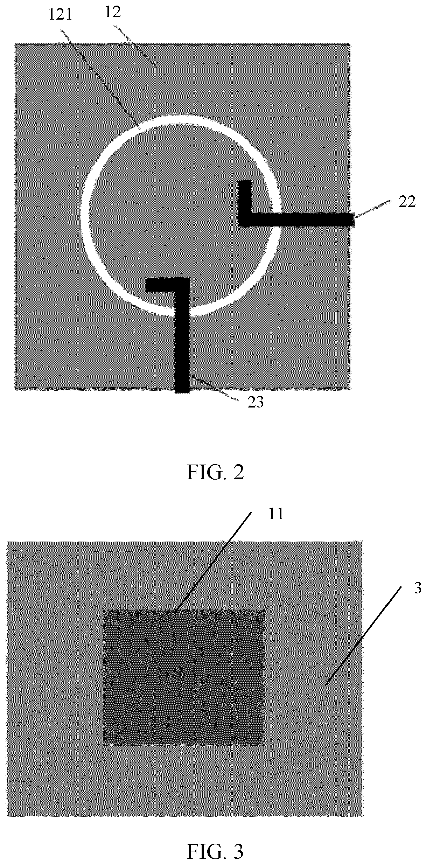

FIG. 1 is a side view of an embodiment of a packaging structure according to this application. FIG. 2 is a bottom view of an embodiment of a packaging structure according to this application. FIG. 3 is a top view of an embodiment of a packaging structure according to this application. As shown in FIG. 1 to FIG. 3, the packaging structure in this embodiment includes: a first radiation plate 11, a second radiation plate 12, and a feeding part 2, where the second radiation plate 12 is disposed below the first radiation plate 11, a slot 121 is disposed on the second radiation plate 12, the slot 121 is in a ring shape, and the feeding part 2 is disposed below the second radiation plate 12.

The feeding part 2 includes a first feeding stub 22 and a second feeding stub 23 that are disposed independently of each other, where the first feeding stub 22 and the second feeding stub 23 are perpendicular to each other and disposed on a substrate below the slot 121, and the first feeding stub 22 and the second feeding stub 23 feed the first radiation plate 11 by using the slot 121.

Optionally, the feeding part 2 further includes a first signal line 24 and a second signal line 25, where the first signal line 24 or the second signal line 25 is configured to transmit a radio frequency signal.

Optionally, the shape of the slot may be a circular ring, an elliptical ring, or a rectangular ring, and may alternatively be a star ring. This is not limited in this embodiment. A radius, a diameter, or a circumference of an area surrounded by the slot 121 may be obtained by testing based on a frequency that needs to be reached by an antenna. Generally, different frequencies correspond to different radiuses, diameters, or circumferences.

In this embodiment of this application, the first signal line 24 is connected to a signal transmit end of a radio frequency circuit, a signal receive end of a radio frequency circuit, or the like, and is configured to transmit a radio frequency signal. In this embodiment of this application, the first feeding stub 22 includes two segments: a main body and a tail end. The segment that is of the first feeding stub 22 and that is connected to the first signal line 24 is referred to as the main body. The main body of the first feeding stub 22 extends on a substrate on which the first feeding stub 22 is located. One end of the main body of the first feeding stub 22 is connected to the first signal line 24, and the other end of the main body is connected to the tail end. The tail end is bent relative to the main body, so that the first feeding stub 22 is folded as a whole to form an angle less than 180 degrees. The angle formed when the first feeding stub 22 is folded as a whole and lengths of the main body and the tail end may be adjusted based on a signal condition. Optionally, the angle formed by folding is 90 degrees, and the length of the tail end may be, for example, 1/10 or 1/8 of a total length of the first feeding stub 22.

The second signal line 25 is connected to a signal transmit end of a radio frequency circuit, a signal receive end of a radio frequency circuit, or the like, and is configured to transmit a radio frequency signal. In this embodiment of this application, the second feeding stub 23 includes two segments: a main body and a tail end. The segment that is of the second feeding stub 23 and that is connected to the second signal line 25 is referred to as the main body. The main body of the second feeding stub 23 extends on a substrate on which the second feeding stub 23 is located. One end of the main body is connected to the second signal line 25, and the other end of the main body of the second feeding stub 23 is connected to the tail end. The tail end is bent relative to the main body, so that the second feeding stub 23 is folded as a whole to form an angle less than 180 degrees. The angle formed when the second feeding stub 23 is folded as a whole and lengths of the main body and the tail end may be adjusted based on a signal condition. Optionally, the angle formed by folding is 90 degrees, and the length of the tail end may be, for example, 1/10 or 1/8 of a total length of the second feeding stub 23.

Referring to FIG. 2, a main body part of the first feeding stub 22 and a main body part of the second feeding stub 23 are perpendicular to each other. In addition, at least a part of the tail end of the first feeding stub 22 is located in a projection below the slot 121, that is, at least a part of the tail end of the first feeding stub 22 is located in a projection of the slot 121 on the substrate on which the first feeding stub is located; and at least a part of the tail end of the second feeding stub 23 is also located in a projection below the slot 121, that is, at least a part of the tail end of the second feeding stub 23 is located in a projection of the slot 121 on the substrate on which the second feeding stub is located.

Optionally, the angle formed when the first feeding stub 22 is folded as a whole and the angle formed when the second feeding stub 23 is folded as a whole may be the same or different, and the angles formed when the two feeding stubs are folded as a whole need to ensure that the first feeding stub 22 and the second feeding stub 23 are independent of each other and do not intersect. The length of the tail end of the first feeding stub 22 and the length of the tail end of the second feeding stub 23 may be the same or different.

The first folded feeding stub 22 and the second folded feeding stub 23 are perpendicular to each other and disposed on the substrate below the slot 121. Optionally, the first folded feeding stub 22 and the second folded feeding stub 23 may be disposed on a same layer of substrate. When the first folded feeding stub 22 and the second folded feeding stub 23 are disposed on the same layer of substrate, an effect of polarization isolation is comparatively good. Alternatively, the first folded feeding stub 22 and the second folded feeding stub 23 may be disposed on different layers of substrates. In this case, two substrates may be disposed up and down in the feeding part 2. Regardless of one substrate or two substrates, a through-hole is disposed on the substrate for the first signal line 24 and the second signal line 25 to pass through.

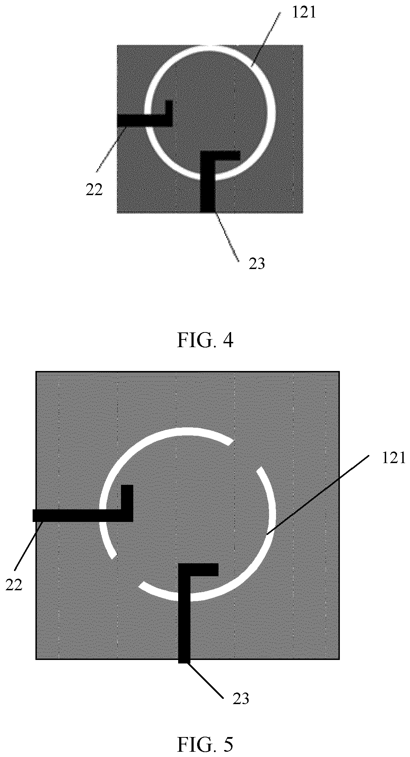

FIG. 4 is a bottom view of a feeding part and a slot in an embodiment of a packaging structure. As shown in FIG. 4, the slot 121 is in a circular ring shape, a part of the tail end of the first feeding stub 22 is located in a projection of the slot 121 on the substrate on which the first feeding stub 22 is located, and a part of the tail end of the second feeding stub 23 is located in a projection of the slot 121 on the substrate on which the second feeding stub 23 is located.

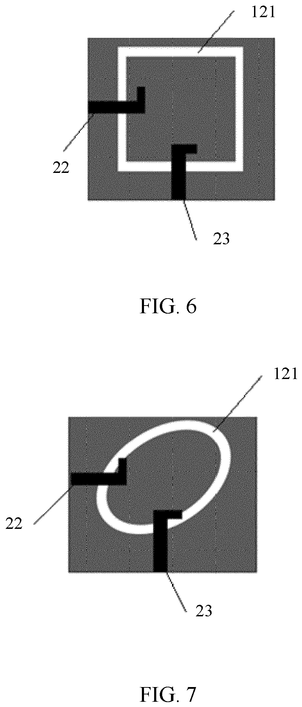

FIG. 6 is a bottom view of a feeding part in an embodiment of a packaging structure. As shown in FIG. 6, the slot 121 is in a rectangular ring shape, which may be a rectangular ring, or may be a square ring; a part of the tail end of the first feeding stub 22 is located in a projection of the slot 121 on the substrate on which the first feeding stub 22 is located; and a part of the tail end of the second feeding stub 23 is located in a projection of the slot 121 on the substrate on which the second feeding stub 23 is located.

FIG. 7 is a bottom view of a feeding part in an embodiment of a packaging structure. As shown in FIG. 7, the slot 121 is in an elliptical ring shape, a part of the tail end of the first feeding stub 22 is located in a projection of the slot 121 on the substrate on which the first feeding stub 22 is located, and a part of the tail end of the second feeding stub 23 is located in a projection of the slot 121 on the substrate on which the second feeding stub 23 is located.

In the foregoing embodiment of this application, the two feeding stubs are disposed on the substrate below the slot 121, and a vertical spacing between the two feeding stubs and the second radiation plate 12 may be set based on measurement of experimental data of a bandwidth that is to be implemented.

In the foregoing embodiment of this application, the first feeding stub 22 and the second feeding stub 23 perform coupling feeding on the first radiation plate 11 by being electromagnetically coupled to the slot 121, to transmit an electromagnetic wave signal.

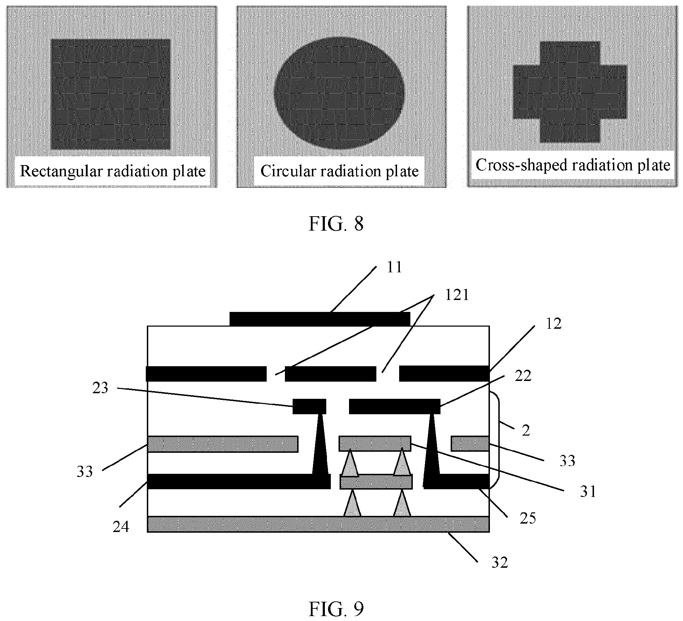

As shown in FIG. 3, the first radiation plate 11 is disposed above a top-layer substrate 3. FIG. 8 is a top view of the first radiation plate. As shown in FIG. 8, optionally, a shape of the first radiation plate 11 may be a rectangle, a circle, or a cross. In this embodiment, a size (an area) of the first radiation plate 11 may be set based on performance that needs to be achieved by an antenna.

Optionally, the first radiation plate 11 is a parasitic patch, and a shape of the parasitic patch may be a rectangle, a circle, or a cross.

FIG. 9 is a side view of an embodiment of a packaging structure according to this application. As shown in FIG. 9, the packaging structure in this embodiment may further include a first ground plate 31 that is disposed between the first signal line 24 and the second signal line 25, where the first ground plate 31 is configured to implement isolation between the signal lines and shield interference between the signal lines. The first ground plate 31 may be made of a metallic material. In this embodiment of this application, two layers of first ground plates 31 are disposed between the first signal line 24 and the second signal line 25. In practice, a quantity of layers of the first ground plate 31 may be increased or decreased based on lengths of the first signal line and the second signal line on a vertical plane. In a scenario in which there is a plurality of layers of first ground plates 31, the plurality of layers of the first ground plates 31 may be connected by using through-holes plated with metal or filled with metal. These through-holes plated with metal or filled with metal can further improve a shielding effect. In an optional embodiment, a plurality of groups of dual-polarized antennas may be packaged together, for example, packaged at a bottom of a chip. Therefore, a third ground plate 33 may also be disposed on two sides of the first signal line 24 and the second signal line 25, as shown in FIG. 9, to isolate interference between different signal lines.

Optionally, as shown in FIG. 9, the dual-polarized antenna in this embodiment may further include a second ground plate 32 that is disposed at a bottom of the feeding part 2. The dual-polarized antenna provided in this application is a packaged antenna. The dual-polarized antenna is usually packaged, by using a packaging process, together with a chip configured to process data. Considering performance of receiving and transmitting a radio frequency signal by the antenna, the antenna is usually packaged on a surface of the chip. However, this also brings a problem that a signal received or transmitted by the antenna causes interference to various functional components in the chip. In this case, the second ground plate 32 disposed at the bottom of the feeding part may be configured to implement signal interference between the antenna and the chip. The first signal line 24 and the second signal line 25 may pass through or bypass the second ground plate 32 in various manners. For example, a through-hole plated with metal or filled with metal is disposed on the second ground plate 32, or the first signal line 24 and the second signal line 25 are communicatively connected to the chip by using a pin on an antenna side in a wired bonding manner. Even if the antenna is not packaged on the surface of the chip, but is instead disposed side by side with the chip on a carrier board, the second ground plate 32 disposed at a bottom of the antenna can also isolate signal interference between the antenna and various signal lines on the carrier board below the antenna.

According to the invention, the packaging structure in this embodiment further includes a substrate and a chip that is fixedly connected to a side of the substrate, where the chip has a plurality of feeding pins, the plurality of feeding pins are connected to the substrate, and the substrate includes the first radiation plate, the second radiation plate, and the feeding part. The chip may be located on a lower surface of the substrate, and the first radiation plate and the second radiation plate may be located on a side that is of the substrate and that is close to an upper surface.

In another embodiment, a dual-polarized antenna in package may be an independent packaging structure, and the packaging structure and a chip are designed to be side by side on a side of a substrate.

According to the packaging structure provided in this embodiment, by disposing the closed ring-shaped slot, the first radiation plate, and the second radiation plate, a bandwidth and a gain can be increased, implementing a wide bandwidth and a high gain. Further, an operating bandwidth of an antenna is extended to a wider frequency band, and the antenna is applicable to a terminal operating on a wide frequency band, expanding an application scope of the antenna. In addition, the slot is set to be in a closed ring shape, and the two feeding stubs are perpendicular to each other. In this case, electric fields corresponding to the two feeding stubs are orthogonal, and comparatively good isolation is achieved between electric fields generated by feeding by the two feeding stubs, thereby implementing comparatively high polarization isolation.

The following uses a specific embodiment to describe in detail the technical solutions of the foregoing embodiment.

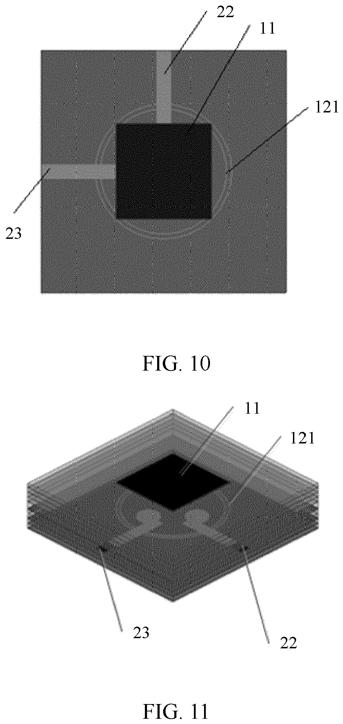

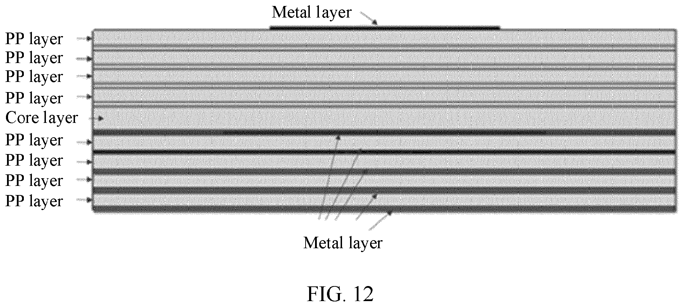

FIG. 10 is a top view of an embodiment of a packaging structure according to this application. FIG. 11 is a side view of an embodiment of a packaging structure according to this application. As shown in FIG. 10 and FIG. 11, in the packaging structure in this embodiment, a first radiation plate 11, a second radiation plate 12 and a feeding part are implemented on ten layers of substrates. In this embodiment, a shape of the first radiation plate 11 is a rectangle. FIG. 12 is a schematic diagram of distribution of a prepreg (Prepreg, PP) layer, a core (core) layer, and a metal layer in a packaging structure according to this application. In this embodiment, a thickness of the PP layer is 60 um, a thickness of the core layer is 100 um, and a thickness of the metal layer is 15 um. In this embodiment, the second radiation plate 12 is disposed below the first radiation plate 11; a slot 121 is disposed on the second radiation plate 12, where the slot 121 is in a closed ring shape; the feeding part 2 is disposed below the second radiation plate 12; the feeding part 2 includes a first feeding stub 22 and a second feeding stub 23 that are disposed independently of each other, a first signal line 24, and a second signal line 25; and the first feeding stub 22 and the second feeding stub 23 are perpendicular to each other and disposed on a same layer of substrate below the slot. The slot 121 in this embodiment is in a circular ring shape. The first feeding stub 22 and the second feeding stub 23 perform coupling feeding on the first radiation plate by being electromagnetically coupled to the slot 121. The first feeding stub 22 and the second feeding stub 23 shown in FIG. 10 are perpendicular to each other. Both the first feeding stub 22 and the second feeding stub 23 are folded at an angle of 90 degrees, and both folded lengths are, for example, 1/10 of a total length of the feeding stub. A part of a tail end of the first feeding stub 22 is located in a projection of the slot 121 on a substrate on which the first feeding stub 22 is located. A part of a tail end of the second feeding stub 23 is located in a projection of the slot 121 on a substrate on which the second feeding stub 23 is located.

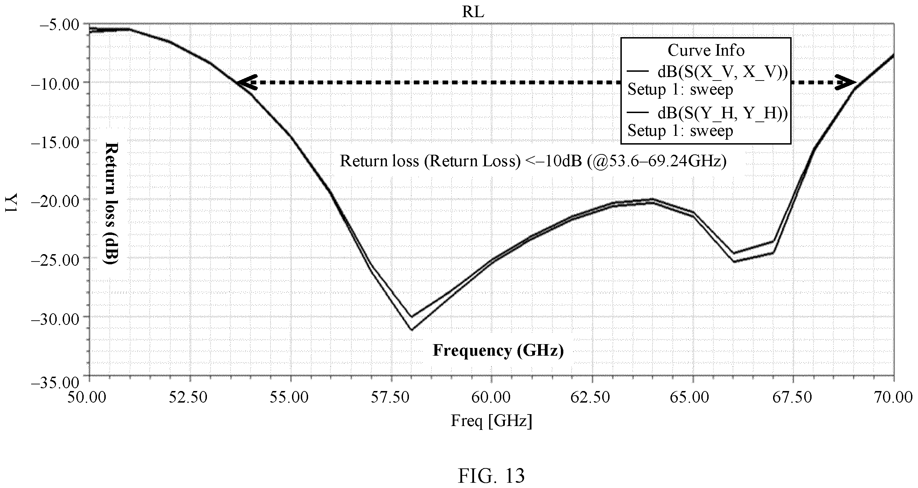

In this embodiment, by disposing the ring-shaped slot, the first radiation plate, and the second radiation plate, a bandwidth and a gain can be increased, implementing a wide bandwidth and a high gain. Further, an operating bandwidth of an antenna is extended to a wider frequency band, and the antenna is applicable to a terminal operating on a wide frequency band, expanding an application scope of the antenna. In addition, the slot is set to be in a ring shape, and the two feeding stubs are perpendicular to each other. In this case, electric fields corresponding to the two feeding stubs are orthogonal, and comparatively good isolation is achieved between electric fields generated by feeding by the two feeding stubs, thereby implementing comparatively high polarization isolation. Comparatively good antenna performance (including a wide bandwidth, a high gain, and comparatively high polarization isolation) may be achieved through emulation. The following describes performance of the packaging structure in the embodiment shown in FIG. 10 and FIG. 11 with reference to emulation results shown in FIG. 13 to FIG. 15.

FIG. 13 is a schematic diagram of an emulation result of a return loss (Return Loss, RL for short) of a packaging structure. As shown in FIG. 13, a horizontal coordinate indicates a frequency, a vertical coordinate indicates a return loss, a frequency range with a return loss less than -10 dB is between 53.6 GHz and 69.24 GHz, and for the return losses less than -10 dB, a displayed bandwidth reaches 15.3 GHz, which is up to a bandwidth percentage of 25.5% (calculated based on a center frequency of 60 GHz). It can be learned that the packaging structure in this embodiment can reach a comparatively wide bandwidth.

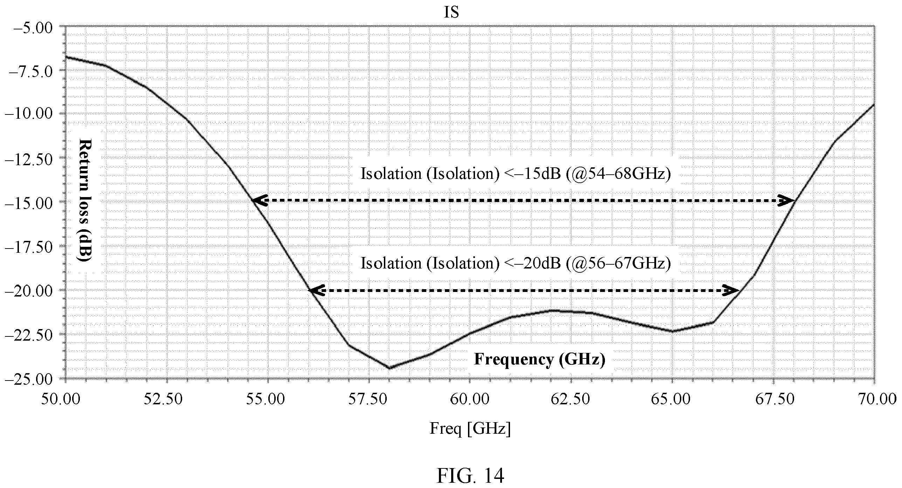

FIG. 14 is a schematic diagram of an emulation result of polarization isolation of a packaging structure. As shown in FIG. 14, a horizontal coordinate indicates a frequency, a vertical coordinate indicates isolation (Isolation), a frequency range with isolation less than -15 dB is between 54 GHz and 68 GHz, and a frequency range with isolation less than -20 dB is between 56 GHz and 67 GHz. It can be learned that the packaging structure in this embodiment implements comparatively high polarization isolation.

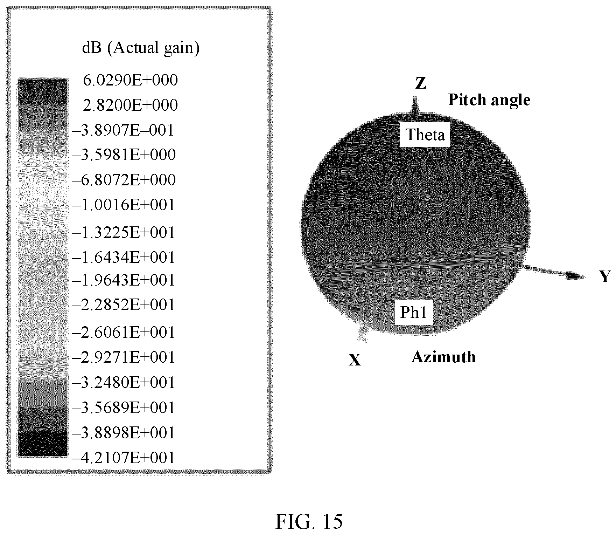

FIG. 15 is a 3D radiation pattern of a packaging structure. It can be learned from the 3D radiation pattern that an antenna gain reaches 6.029 dBi, the gain is high, and radiation is wide. In terms of a radiation pattern, each section is comparatively balanced. This greatly facilitates subsequent array integration. It can be learned that the packaging structure in this embodiment achieves a comparatively high gain.

In addition, it should be noted that the slots in the embodiments in FIG. 4, FIG. 6, and FIG. 7 of this application are all closed rings, for example, a complete ring, a complete elliptical ring, and a complete rectangular ring. However, in an actual product, the slot on the second radiation plate may alternatively be an unclosed ring, that is, the ring-shaped slot does not extend continuously. FIG. 5 is a bottom view of a feeding part in an embodiment of a packaging structure. For example, as shown in FIG. 5, a slot 121 is in a circular ring shape, but the slot 121 is not continuous as a whole, and is formed by two parts of arcs on a second radiation plate. The two parts of arcs are separated in between by a part of a structure of the second radiation plate, but are spliced as a whole to form the slot in the circular ring shape.

Performance effects achieved by the packaging structure in this embodiment of this application bring a quite large engineering margin. In addition, a processing period for a small quantity of stacked layers of substrates is very short and the process is mature. After being synchronously processed, the substrates are packaged in a unified manner, which can greatly reduce the processing period and processing costs. Compared with an existing solution, manufacturing process time is shortened, costs can be reduced, and a performance margin is large. Therefore, a product yield rate is easy to achieve, and the packaging structure is more suitable for mass production when being applied to an antenna array.

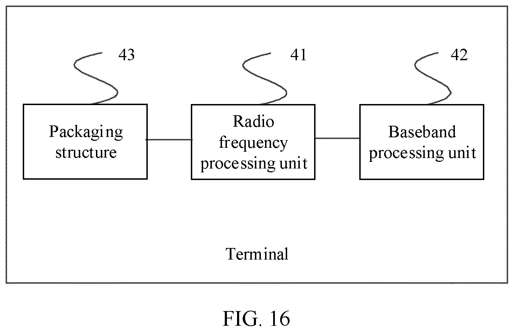

FIG. 16 is a schematic structural diagram of an embodiment of a terminal according to this application. As shown in FIG. 16, the terminal in this embodiment may include a radio frequency processing unit 41, a baseband processing unit 42, and a packaging structure 43.

For a structure of the packaging structure 43, reference may be made to the description in the foregoing embodiments, and details are not described herein again.

The terminal provided in this embodiment may be a communications terminal such as a data card, a wireless network card, a wireless router, a mobile phone, a wearable device, glasses, or a media apparatus.

The foregoing implementations, schematic structural diagrams, or schematic emulation diagrams are merely examples for describing the technical solutions of this application. Size proportions and emulation values thereof do not constitute a limitation on the protection scope of the technical solutions.

## Claims

1. A packaging structure for an antenna, comprising:
a first radiation plate (11), a second radiation plate (12), and a feeding part, wherein
the second radiation plate is disposed below the first radiation plate, a slot (121) is disposed on the second radiation plate, wherein the slot is in a ring shape, and the feeding part is disposed below the second radiation plate; and
the feeding part comprises a first feeding stub (22) and a second feeding stub (23) that are disposed independently of each other, wherein the first feeding stub and the second feeding stub are perpendicular to each other and disposed on a substrate below the slot, and the first feeding stub and the second feeding stub are configured to feed the first radiation plate by being electromagnetically coupled to the slot; wherein the packaging structure further comprises a substrate and a chip that is fixedly connected to a side of the substrate, wherein the chip has a plurality of feeding pins, the plurality of feeding pins are connected to the substrate, and the substrate comprises the first radiation plate, the second radiation plate, and the feeding part.

2. The packaging structure according to claim 1, wherein the first feeding stub comprises a main body and a tail end, wherein the tail end is bent relative to the main body, the main body of the first feeding stub extends or the substrate, one end of the main body of the first feeding stub is connected to a first signal line, and the other end of the main body of the first feeding stub is connected to the tail end of the first feeding stub; and
the second feeding stub comprises a main body and a tail end, wherein the tail end is bent relative to the main body, the main body of the second feeding stub extends on the substrate, one end of the main body of the second feeding stub is connected to a second signal line, and the other end of the main body of the second feeding stub is connected to the tail end of the second feeding stub.

3. The packaging structure according to claim 2, wherein at least a part of the tail end of the first feeding stub is located in a projection of the slot on the substrate; and
at least a part of the tail end of the second feeding stub is located in a projection of the slot on the substrate.

4. The packaging structure according to any one of claims 1 to 3, wherein the first feeding stub and the second feeding stub are disposed on a same layer of the substrate

5. The packaging structure according to any one of claims 1 to 3, wherein the slot is in a closed ring shape.

6. The packaging structure according to any one of claims 1 to 5, wherein a shape of the slot is a circular ring, an elliptical ring, a rectangular ring, or a star ring.

7. The packaging structure according to any one of claims 1 to 5, wherein a shape of the first radiation plate is a rectangle, a circle, or a cross.

8. The packaging structure according to any one of claims 1 to 7, wherein the first radiation plate is a parasitic patch.

9. The packaging structure according to any one of claims 2 to 8, wherein the packaging structure further comprises:
a first ground plate (31) that is disposed between the first signal line and the second signal line.

10. The packaging structure according to any one of claims 1 to 9, wherein the packaging structure further comprises:
a second ground plate (32) that is disposed at a bottom of the feeding part.

## Patentansprüche

1. Verpackungsstruktur für eine Antenne, umfassend:
eine erste Strahlungsplatte (11), eine zweite Strahlungsplatte (12) und ein Zuführungsteil, wobei
die zweite Strahlungsplatte unterhalb der ersten Strahlungsplatte angeordnet ist, ein Schlitz (121) auf der zweiten Strahlungsplatte angeordnet ist, wobei der Schlitz ringförmig ist, und das Zuführungsteil unter der zweiten Strahlungsplatte angeordnet ist; und
das Zuführungsteil einen ersten Zuführungs-Stub (22) und einen zweiten Zuführungs-Stub (23) umfasst, die unabhängig voneinander angeordnet sind, wobei der erste Zuführungs-Stub und der zweite Zuführungs-Stub senkrecht zueinander sind und auf einem Substrat unterhalb des Schlitzes angeordnet sind, und der erste Zuführungs-Stub und der zweite Zuführungs-Stub konfiguriert sind, um der ersten Strahlungsplatte zuzuführen, indem sie mit dem Schlitz elektromagnetisch gekoppelt werden;
wobei die Verpackungsstruktur ferner ein Substrat und einen Chip umfasst, der mit einer Seite des Substrats fest verbunden ist, wobei der Chip eine Vielzahl von Zuführungsstiften aufweist, wobei die Vielzahl von Zuführungsstiften mit dem Substrat verbunden sind und das Substrat die erste Strahlungsplatte, die zweite Strahlungsplatte und das Zuführungsteil umfasst.

2. Verpackungsstruktur nach Anspruch 1, wobei der erste Zuführungs-Stub einen Hauptkörper und ein hinteres Ende umfasst, wobei das hintere Ende relativ zu dem Hauptkörper gebogen ist, wobei sich der Hauptkörper des ersten Zuführungs-Stub auf dem Substrat erstreckt, wobei ein Ende des Hauptkörpers des ersten Zuführungs-Stub mit einer ersten Signalleitung verbunden ist und das andere Ende des Hauptkörpers des ersten Zuführungs-Stub mit dem hinteren Ende des ersten Zuführungs-Stub verbunden ist; und
der zweite Zuführungs-Stub einen Hauptkörper und ein hinteres Ende umfasst, wobei das hintere Ende relativ zu dem Hauptkörper gebogen ist, wobei sich der Hauptkörper des zweiten Zuführungs-Stub auf dem Substrat erstreckt, wobei ein Ende des Hauptkörpers des zweiten Zuführungs-Stub mit einer zweiten Signalleitung verbunden ist und das andere Ende des Hauptkörpers des zweiten Zuführungs-Stub mit dem hinteren Ende des zweiten Zuführungs-Stub verbunden ist.

3. Verpackungsstruktur nach Anspruch 2, wobei sich mindestens ein Teil des hinteren Endes des ersten Zuführungs-Stub in einem Vorsprung des Schlitzes auf dem Substrat befindet; und
sich mindestens ein Teil des hinteren Endes des zweiten Zuführungs-Stub in einem Vorsprung des Schlitzes auf dem Substrat befindet.

4. Verpackungsstruktur nach einem der Ansprüche 1 bis 3, wobei der erste Zuführungs-Stub und der zweite Zuführungs-Stub auf einer gleichen Schicht des Substrats angeordnet sind.

5. Verpackungsstruktur nach einem der Ansprüche 1 bis 3, wobei der Schlitz in Form eines geschlossenen Rings vorliegt.

6. Verpackungsstruktur nach einem der Ansprüche 1 bis 5, wobei eine Form des Schlitzes ein Kreisring, ein elliptischer Ring, ein rechteckiger Ring oder ein Sternring ist.

7. Verpackungsstruktur nach einem der Ansprüche 1 bis 5, wobei eine Form der ersten Strahlungsplatte ein Rechteck, ein Kreis oder ein Kreuz ist.

8. Verpackungsstruktur nach einem der Ansprüche 1 bis 7, wobei die erste Strahlungsplatte ein parasitäres Patchelement ist.

9. Verpackungsstruktur nach einem der Ansprüche 2 bis 8, wobei die Verpackungsstruktur ferner umfasst:
eine erste Erdungsplatte (31), die zwischen der ersten Signalleitung und der zweiten Signalleitung angeordnet ist.

10. Verpackungsstruktur nach einem der Ansprüche 1 bis 9, wobei die Verpackungsstruktur ferner umfasst:
eine zweite Erdungsplatte (32), die an einem Boden des Zuführungsteils angeordnet ist.

## Revendications

1. Structure de mise sous boîtier destinée à une antenne, comprenant :
une première plaque de rayonnement (11), une seconde plaque de rayonnement (12) et une partie d'alimentation, dans laquelle la seconde plaque de rayonnement est disposée sous la première plaque de rayonnement, une fente (121) est disposée sur la seconde plaque de rayonnement, dans laquelle la fente est en forme d'anneau, et la partie d'alimentation est disposée sous la seconde plaque de rayonnement ; et
la partie d'alimentation comprend un premier tronçon d'alimentation (22) et un second tronçon d'alimentation (23) qui sont disposés indépendamment l'un de l'autre, dans laquelle le premier tronçon d'alimentation et le second tronçon d'alimentation sont perpendiculaires l'un à l'autre et disposés sur un substrat sous la fente, et le premier tronçon d'alimentation et le second tronçon d'alimentation sont configurés pour alimenter la première plaque de rayonnement en étant couplés électromagnétiquement à la fente ; dans laquelle la structure de mise sous boîtier comprend en outre un substrat et une puce qui est connectée à demeure sur un côté du substrat, dans laquelle la puce a une pluralité de broches d'alimentation, la pluralité de broches d'alimentation sont connectées au substrat et le substrat comprend la première plaque de rayonnement, la seconde plaque de rayonnement et la partie d'alimentation.

2. Structure de mise sous boîtier selon la revendication 1, dans laquelle le premier tronçon d'alimentation comprend un corps principal et une extrémité arrière, dans laquelle l'extrémité arrière est pliée par rapport au corps principal, le corps principal du premier tronçon d'alimentation s'étend sur le substrat, une extrémité du corps principal du premier tronçon d'alimentation est connectée à une première ligne de signal, et l'autre extrémité du corps principal du premier tronçon d'alimentation est connectée à l'extrémité arrière du premier tronçon d'alimentation ; et
le second tronçon d'alimentation comprend un corps principal et une extrémité arrière, dans laquelle l'extrémité arrière est pliée par rapport au corps principal, le corps principal du second tronçon d'alimentation s'étend sur le substrat, une extrémité du corps principal du second tronçon d'alimentation est connectée à une seconde ligne de signal, et l'autre extrémité du corps principal du second tronçon d'alimentation est connectée à l'extrémité arrière du second tronçon d'alimentation.

3. Structure de mise sous boîtier selon la revendication 2, dans laquelle au moins une partie de l'extrémité arrière du premier tronçon d'alimentation est située dans une saillie de la fente sur le substrat ; et
au moins une partie de l'extrémité arrière du second tronçon d'alimentation est située dans une saillie de la fente sur le substrat.

4. Structure de mise sous boîtier selon l'une quelconque des revendications 1 à 3, dans laquelle le premier tronçon d'alimentation et le second tronçon d'alimentation sont disposés sur une même couche du substrat.

5. Structure de mise sous boîtier selon l'une quelconque des revendications 1 à 3, dans laquelle la fente est en forme d'anneau fermé.

6. Structure de mise sous boîtier selon l'une quelconque des revendications 1 à 5, dans laquelle une forme de la fente est un anneau circulaire, un anneau elliptique, un anneau rectangulaire ou un anneau en étoile.

7. Structure de mise sous boîtier selon l'une quelconque des revendications 1 à 5, dans laquelle une forme de la première plaque de rayonnement est un rectangle, un cercle ou une croix.

8. Structure de mise sous boîtier selon l'une quelconque des revendications 1 à 7, dans laquelle la première plaque de rayonnement est une pièce parasite.

9. Structure de mise sous boîtier selon l'une quelconque des revendications 2 à 8, dans laquelle la structure de mise sous boîtier comprend en outre :
une première plaque de masse (31) qui est disposée entre la première ligne de signal et la seconde ligne de signal.

10. Structure de mise sous boîtier selon l'une quelconque des revendications 1 à 9, dans laquelle la structure de mise sous boîtier comprend en outre :
une seconde plaque de masse (32) qui est disposée au niveau d'un fond de la partie d'alimentation.
